# EUROPEAN PATENT APPLICATION

(11) **EP 4 589 316 A1**
(43) Date of publication of application: **23.07.2025**
(21) Application number: 23875154.9
(22) Date of filing: 26.09.2023
(51) Int. Cl.: G01R 31/367, G01R 31/396, G01R 31/392

(54) **DEVICE FOR DETERMINING STATE OF BATTERY CELL, AND OPERATING METHOD THEREFOR**

(30) Priority: 04.10.2022 KR 20220126528
(71) Applicant: LG Energy Solution, Ltd., Seoul 07335 (KR)
(72) Inventor: PARK, Hyung Oak, Daejeon 34122 (KR); CHOI, Jee Soon, Daejeon 34122 (KR)
(74) Representative: Plasseraud IP
(86) International application number: PCT/KR2023/014884
(87) International publication number: WO 2024/076089

(57) **Abstract**

A battery cell state determination apparatus according to an embodiment of the present disclosure may include a first module configured to generate first state information regarding a battery cell, based on a time-series data set regarding the battery cell and a second module configured to generate second state information regarding the battery cell, based on the time-series data set, in which the first module is further configured to perform learning using teacher forcing based on the second state information.

## Description

### [TECHNICAL FIELD]

### CROSS-REFERENCE TO RELATED APPLICATION

This application claims priority to and the benefit of Korean Patent Application No. 10-2022-0126528 filed in the Korean Intellectual Property Office on October 4, 2022, the entire content of which is incorporated herein by reference.

### TECHNICAL FIELD

Embodiments disclosed herein relate to a battery cell state determination apparatus and an operating method thereof.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. A lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Batteries tend to deteriorate as they are repeatedly charged and discharged. For example, as batteries are repeatedly charged and discharged, their capacity and resistance may deteriorate and their remaining life may decrease. In addition, the degree of deterioration and remaining life of the battery may change depending on use conditions.

When the remaining life of the battery rapidly decreases, safety issues may occur in the use of the battery. Accordingly, there is a need for a method of preventing a risk caused by a sudden drop in battery performance by determining a state of the battery.

### [DISCLOSURE]

### [TECHNICAL PROBLEM]

Embodiments disclosed herein aim to provide an apparatus including a first module for determining a state of a battery cell based on a time-series data set of the battery cell, and an operating method of the apparatus.

Embodiments disclosed herein also aim to provide an apparatus performing learning based on an experimental data set collected under a preset experimental condition and determining a battery state based on a time-series data set, and an operating method of the apparatus.

Technical problems of the embodiments disclosed herein are not limited to the above-described technical problems, and other unmentioned technical problems would be clearly understood by one of ordinary skill in the art from the following description.

### [TECHNICAL SOLUTION]

A battery cell state determination apparatus according to an embodiment of the present disclosure may include a first module configured to generate first state information regarding a battery cell, based on a time-series data set regarding the battery cell and a second module configured to generate second state information regarding the battery cell, based on the time-series data set, in which the first module is further configured to perform learning using teacher forcing based on the second state information.

According to an embodiment, the time-series data set may include a plurality of time-series tokens which are consecutive data having a temporal property.

According to an embodiment, the first module may include an encoder block configured to extract context information of the time-series data set from a first time-series token included in the time-series data set, a decoder block configured to generate prediction data, based on context information of the time-series data set and a second time-series token included in the time-series data set, and a determination block configured to generate the first state information based on the prediction data and a third time-series token included in the time-series data set.

According to an embodiment, the first module may be further configured to correct the prediction data based on the second state information.

According to an embodiment, the third time-series token may be data collected from the battery cell at a time point when a state of the battery cell is determined.

According to an embodiment, the third time-series token may be data predicted to be collected from the battery cell when the battery cell is in a normal state.

According to an embodiment, the second module may include a long short-term memory block configured to extract a first feature based on the time-series data set, a convolution block configured to extract a second feature based on the time-series data set, and a combination block configured to generate the second state information by combining the first feature with the second feature.

According to an embodiment, the long short-term memory block may include a recurrent layer configured to recurrently process the time-series data set and a memory layer configured to preserve a processing result of the recurrent layer.

According to an embodiment, the convolution block may include a convolution layer configured to perform a convolution operation with respect to the time-series data set.

According to an embodiment, the convolution block may include a compression layer configured to compress an operation result of the convolution layer and an active layer configured to correct the operation result of the convolution layer based on an operation result of the compression layer.

According to an embodiment, the second module may be further configured to perform learning based on an experimental data set, and the experimental data set may be a data set in which data of an experimental battery cell, collected under a preset experimental condition, and state information of the experimental battery cell are matched to each other.

According to another embodiment of the present disclosure, an operating method of a battery cell state determination apparatus includes collecting a time-series data set for a battery cell, generating first state information regarding the battery cell, based on the time-series data set, generating second state information regarding the battery cell, based on the time-series data set, and performing teacher forcing based on the second state information.

According to another embodiment, the generating of the first state information may include extracting context information of the time-series data set from a first time-series token included in the time-series data set, generating prediction data, based on context information of the time-series data set and a second time-series token included in the time-series data set, and generating the first state information based on the prediction data and a third time-series token included in the time-series data set.

According to another embodiment, the generating of the second state information may include extracting a first feature based on the time-series data set, extracting a second feature based on the time-series data set, and generating the second state information by combining the first feature with the second feature.

According to another embodiment, the extracting of the first feature may include recurrently processing the time-series time set, preserving a recurrent processing result with respect to the time-series data set, and extracting the first feature based on the preserved recurrent processing result.

According to another embodiment, the extracting of the second feature may include performing a convolution operation with respect to the time-series data set, compressing a result of the convolution operation, and extracting the second feature by correcting the result of the convolution operation based on a result of the compression.

According to another embodiment, the operating method may further include learning a generation method of the second state information based on an experimental data set, in which the experimental data set is a data set in which data of an experimental battery cell, collected under a preset experimental condition, and state information of the experimental battery cell are matched to each other.

### [ADVANTAGEOUS EFFECTS]

A battery cell state prediction apparatus and an operating method thereof according to an embodiment disclosed herein may predict a state of a battery cell based on time-series data.

The battery cell state prediction apparatus and the operating method thereof according to an embodiment disclosed herein may verify a prediction result based on the time-series data, on the basis of experimental data collected under a preset condition.

The battery cell state prediction apparatus and the operating method thereof according to an embodiment disclosed herein may generate state information corresponding to a state of a battery cell after time-series data is collected.

A battery cell state determination apparatus and an operating method thereof according to an embodiment disclosed herein may improve the accuracy of prediction of the state information based on the experimental data.

Moreover, various effects recognized directly or indirectly from the disclosure may be provided.

### [DESCRIPTION OF DRAWINGS]

FIG. 1 is a block diagram of a battery cell state determination apparatus according to an embodiment disclosed herein.
FIG. 2 is a block diagram showing a first module according to an embodiment disclosed herein.
FIG. 3 is a block diagram showing a second module according to an embodiment disclosed herein.
FIG. 4 is a flowchart of a battery cell state determination method of a first module according to an embodiment disclosed herein.
FIG. 5 is a flowchart of a battery cell state determination method of a second module according to an embodiment disclosed herein.
FIG. 6 is a flowchart of an operating method of a battery cell state determination apparatus according to an embodiment disclosed herein.
FIG. 7 is a flowchart of a first state information generation method according to an embodiment disclosed herein.
FIG. 8 is a flowchart of a second state information generation method according to an embodiment disclosed herein.
FIG. 9 is a flowchart of a second state information generation method according to another embodiment disclosed herein.
FIG. 10 is a block diagram showing a hardware configuration of a computing system for performing an operating method of a battery cell state determination apparatus, according to an embodiment disclosed herein.

### [MODE FOR INVENTION]

Hereinafter, embodiments disclosed in this document will be described in detali with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

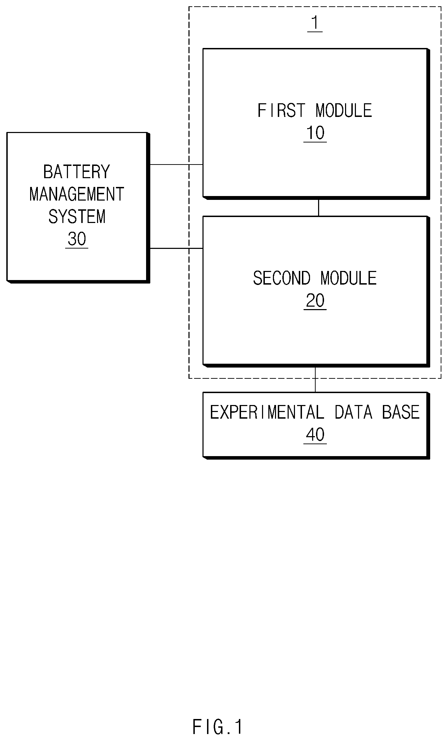

FIG. 1 is a block diagram of a battery cell state determination apparatus according to an embodiment disclosed herein.

Referring to FIG. 1, a battery cell state determination apparatus 1 according to an embodiment disclosed herein may include a first module 10 and a second module 20.

The first module 10 and the second module 20 may be connected to a battery management system 30 that transmits a time-series data set regarding a battery cell, and the second module 20 may be connected to an experimental data base 40 that transmits an experimental data set.

The first module 10 may generate first state information regarding the battery cell, based on the time-series data set regarding the battery cell.

The first state information regarding the battery cell may be information obtained by predicting a state of the battery cell by the first module 10. The first state information may include information regarding determination of whether the battery cell is in a normal state or an abnormal state.

The first module 10 may generate prediction data regarding a state of the battery cell at a preset time point based on the collected time-series data set and determine the state of the battery cell based on the prediction data.

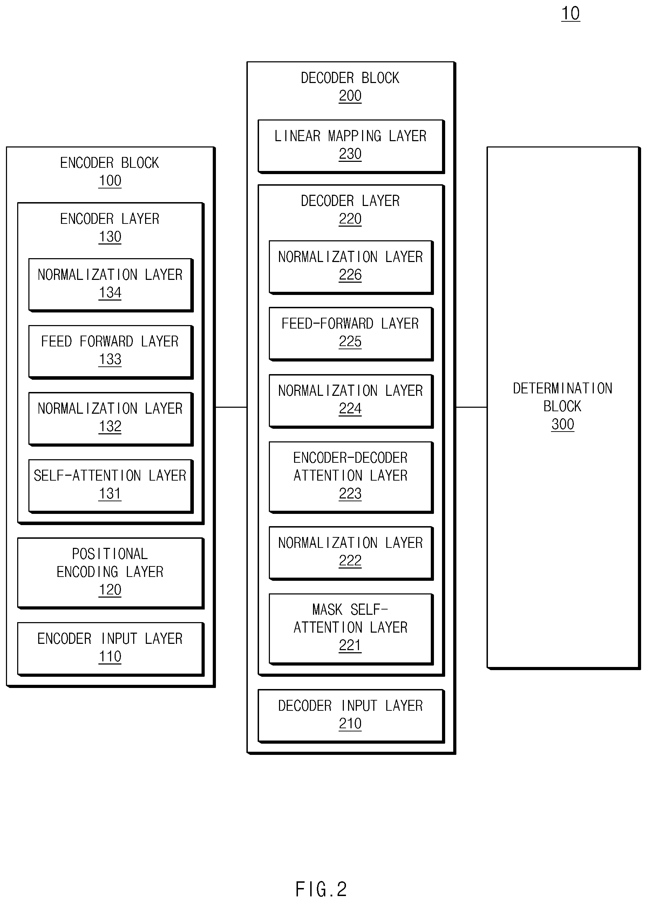

A battery cell state determination method of the first module 10 will be described in detail with reference to FIG. 2.

The second module 20 may generate second state information regarding the battery cell, based on the time-series data set regarding the battery cell.

The second state information regarding the battery cell may be state information of the battery cell, corresponding to the collected time-series data set, and include information regarding determination of whether the battery cell is in the normal state or in the abnormal state, like the first state information.

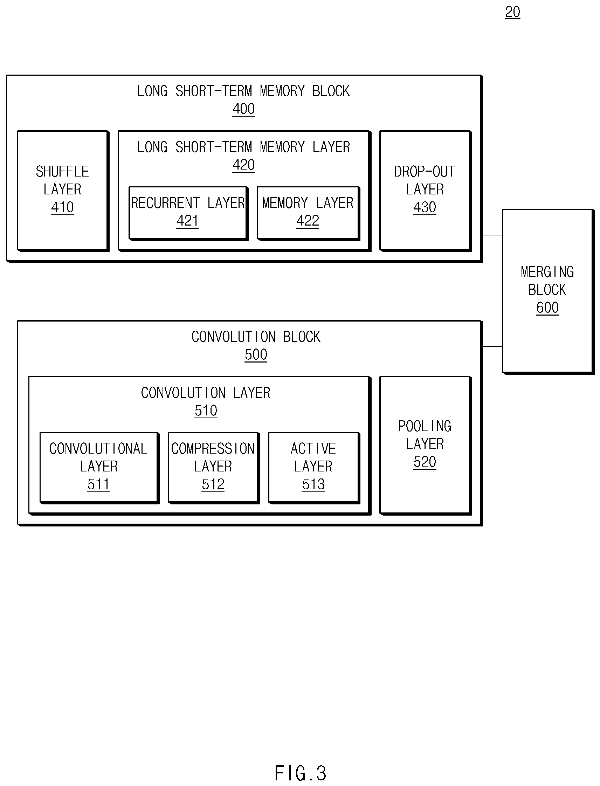

A battery cell state determination method of the second module 20 will be described in detail with reference to FIG. 3.

The battery management system 30 may collect, from a battery cell that is a state determination target in real time, information about the battery cell. The information about the battery cell, collected in real time, may be a time-series data set regarding the battery cell and may be provided to the first module 10 and the second module 20.

The time-series data set regarding the battery cell may include a plurality of time-series tokens. According to an embodiment, the time-series tokens may be time window-specific data in which a preset time window is applied to the data collected in real time from the battery cell.

According to another embodiment, the time-series tokens may be time window-specific data in which a feature value of the data collected in real time from the battery cell may be calculated and the preset time window is applied to the calculated feature value.

According to an embodiment, the battery management system 30 may be connected to a battery module including the battery cell and collect the data regarding the battery cell from the battery module. The data collected by the battery management system 30 may be raw data such as a voltage, a current, a temperature, an internal resistance, an impedance, etc., of the battery cell.

The battery management system 30 may calculate a capacity of the battery cell, a state of health (SOH) of the battery cell, a state of charge (SOC) of the battery cell, a remaining useful life (RUL) of the battery cell, a charge change value for voltage change, etc., from the raw data. The calculation results may be statistical calculation values for the battery cell.

The battery management system 30 may be included in a vehicle. The battery management system 30 may apply a time window to data collected in actual driving of the vehicle and transmit the data as a time-series data set to the first module 10 and the second module 20. According to another embodiment, the battery management system 30 may calculate a feature value of the data collected in actual driving of the vehicle, apply a preset time window to the calculated feature value, and transmit the calculated feature value as a time-series data set to the first module 10 and the second module 20. The time window-applied data may be time-series tokens that are time window-specific data.

The experimental data base 40 may store data of an experimental battery cell, collected under a preset experimental condition, and transmit the data of the experimental battery cell as an experimental data set to the second module 20.

The experimental data set may be a data set in which the data of the experimental data cell and state information of the experimental battery cell are matched to each other.

For example, the experimental data set may be a data set in which an experimental data token obtained by applying a time window to data collected from an experimental battery and state information of the experimental battery cell, corresponding to each experimental data token, are matched to each other. The state information of the experimental battery cell may include information regarding determination of whether the experimental battery cell is in the normal state or the abnormal state.

The experimental data base 40 may receive data of an experimental battery cell from a plurality of experimental battery cells operating under a preset experimental condition. The state information of the experimental battery cell may be calculated by an experimental battery management system including the experimental battery cell or by the experimental data base 40.

The experimental data base 40 may transmit an experimental data set to which state information is matched to the second module 20.

The second module 20 may learn a state information generation method based on the time-series data set of the battery cell, on the basis of the received experimental data set.

That is, the second module 20 may learn the state information generation method based on the data set of the experimental battery cell to which the state information is matched, and generate second state information from the time-series data set through the learned state information generation method.

The second state information generated by the second module 20 may be a basis of teacher forcing of the first module 10.

Teacher forcing may be a method of improving the accuracy of learning by proposing ground truth for an input value together in module learning.

According to an embodiment, the second state information for the time-series data set may be generated through the second module 20 having completed learning based on the experimental data set, and the second state information may be input to the first module 10 as ground truth for the time-series data set, thereby improving the accuracy of the first state information generated by the first module 10.

The first module 10 may receive the time-series data set and the second state information generated from the time-series data set, thereby improving the accuracy of prediction data generation for first state information generation.

The first module 10 may receive the second state information from the second module 20 and may perform learning based on the received second state information.

According to an embodiment, the first module 10 may improve the accuracy of prediction data by applying the second state information to prediction data generation. The first module 10 may learn a prediction data generation method to generate first state information matching the input second state information, thereby improving the accuracy of prediction data generated based on the time-series data set. That is, the first module 10 may perform teacher forcing by applying the second state information to the first state information.

Learning performed by the second module 20 based on the experimental data set may be performed before generation of the second state information based on a real-time data set. In addition, learning performed by the second module 20 based on the experimental data set may be performed before learning performed by the first module 10.

FIG. 2 is a block diagram showing a first module according to an embodiment disclosed herein.

The first module 10 may include an encoder block 100 that extracts context information of a time-series data set, a decoder block 200 that generates prediction data based on the context information of the time-series data set, and a determination block 300 that generates first state information based on the prediction data.

The first module 10 may be a transformer model that learns and predicts consecutive data based on attention. The attention may be a data processing scheme that applies weight values based on relation among input tokens to improve the accuracy of data processing.

The first module 10 may receive a time-series data set including a plurality of time-series token.

According to an embodiment, the time-series token may be time window-specific data generated by applying the preset time window to the time-series data collected by the battery management system 30 from the battery cell.

The first module 10 may generate the prediction data by using the plurality of time-series data tokens and generate the first state information regarding the battery cell based on the generated prediction data.

According to an embodiment, the first module 10 may generate the first state information based on a first time-series token, a second time-series token, and a third time-series token, included in the time-series data set.

The encoder block 100 included in the first module 10 may extract context information of the time-series data set from the first time-series token included in the time-series data set.

The first time-series token may include a plurality of tokens for a preset window to extract the context information of the entire time-series data set.

According to an embodiment, the first time-series token may be set differently according to a learning method of the first module 10. The first time-series token may share tokens for a certain time window with the second time-series token input to the decoder block 200.

According to another embodiment, the first time-series token may include tokens for a time window preceding the second time-series token.

The first time-series tokens may include consecutive tokens having a temporal property or an order to extract the context information of the time-series data set. For example, the first time-series tokens may be obtained by applying a preset time window to consecutive data collected from a battery cell that is subject to state determination. Thus, the first time-series tokens may be consecutive sequence data for the battery cell that is subject to determination.

The encoder block 100 may include an encoder input layer 110 that converts input tokens into a dimension that may be learned or processed, a positional encoder layer 120 that includes relative positions of the converted tokens of the encoder input layer 110, and an encoder layer 130 that extracts context information from the tokens.

The encoder input layer 110 may quantify a plurality of tokens included in the first time-series token through feature extraction. More specifically, the encoder input layer 110 may vectorize the plurality of tokens and map each token onto a geometric space.

According to an embodiment, the encoder input layer 110 may be an embedding layer, and the tokens processed in the encoder input layer 110 may be referred to as an embedding vector.

The positional encoding layer 120 may add position information to the embedding vector to apply the position information of the plurality of tokens included in the first time-series token to learning or data processing.

The first module 10 may receive, at a time, the time-series data that is a basis for learning or processing, and reflect position information between the tokens through the positional encoding layer 120. That is, the positional encoding layer 120 may apply relation among the tokens to learning and prediction.

The encoder block 100 may include a plurality of encoder layers 130, the number of which may be a tuning value for optimization as a hyper parameter.

The encoder layer 130 may perform self-attention on vectors corresponding to the input first time-series token and pass context information obtained through self-attention to the decoder layer 220.

The encoder layer 130 may include a self-attention layer 131, a normalization layer 132, a feed-forward layer 133, and a normalization layer 134.

The self-attention layer 131 may linearly transform a vector for the tokens included in the input first time-series token to generate a query vector, a key vector, and a value vector.

The self-attention layer 131 may perform attention based on the tokens included in the first time-series token.

The self-attention layer 131 may perform attention for all of the tokens included in the first time-series token.

The attention may be an operation of, for each token included in the first time-series token, generating a query vector, a key vector, and a value vector using weight value matrices and generating an output vector having an attention value for all of the tokens included in the input first time-series token by using the query vector, the key vector, and the value vector for all of the tokens.

The self-attention layer 131 may calculate the weight value matrices and a vector of an input token to generate the query vector, the key vector, and the value vector.

The weight value matrices for generating the query vector, the key vector, and the value vector may be parameters updated during a learning process.

The self-attention layer 131 may calculate a similarity with all key vectors corresponding to the respective tokens for query vectors corresponding to the respective tokens and apply the similarity as a weight value to each value vector mapped to each corresponding key vector. A sum of vectors to which the weight value is applied may be an output vector having an attention value for all of the tokens.

According to an embodiment, the self-attention layer 131 may generate a plurality of output vectors by performing attention on the first time-series token several times in parallel. The attention may be performed through a different weight value matrix. An operation of performing attention several times in parallel may be referred to as multi-head attention. The number of attentions performed in parallel may be a tuning value for optimization.

The self-attention layer 131 may connect output vectors generated as results of parallel attention and multiply them by an additional weight value matrix.

The normalization layer 132 may add the vector input to the self-attention layer 131 to the vector output from the self-attention layer 131 and normalize the summed vector, thereby preventing a loss of information. That is, the normalization layer 132 may perform residual connection and layer normalization on the output of the self-attention layer 131.

The feed-forward layer 133 may be a fully connected layer including a plurality of hidden layers. A vector input to the feed-forward layer 133 may be output under an influence of a weight value applied between the hidden layers included in the feed-forward layer 133. The size of the hidden layers included in the feed-forward layer 133 may be a tuning value for optimization.

The normalization layer 134 may add the vector input to the feed-forward layer 133 to the vector output from the feed-forward layer 133 and normalize the summed vector, thereby preventing a loss of information. That is, the normalization layer 134 may perform residual connection and layer normalization on the output of the feed-forward layer 133.

The operations may be repeated as many times as the number of encoder layers 130. The vector output from the encoder layers 130 may have the same magnitude as a vector input from the positional encoding layer 120 to the encoder layer 130.

The encoder block 100 may pass an output value of the encoder layer 130 as context information to the decoder layer 200.

The encoder block 100 may perform the foregoing operation and update the context information each time when the time-series data set is input from the battery management system 30 to the first module 10.

According to an embodiment, the context information may be a set of key vectors and value vectors obtained from input time-series data sets.

The decoder block 200 may generate an output sequence corresponding to prediction data based on the second time-series token included in the time-series data set and the context information output from the encoder block 100.

The decoder block 200 may include a decoder input layer 210 that converts input tokens into a dimension that may be learned or processed, a decoding layer 220 that performs decoding based on the converted tokens of the decoder input layer 210, and a linear mapping layer 230 for generating an output sequence.

The decoder input layer 210 may quantify the plurality of tokens included in the second time-series token input to the decoder block 200 through feature extraction, like the encoder input layer 110. More specifically, the decoder input layer 210 may vectorize the plurality of tokens and map each token onto the geometric space.

The second time-series token may include the plurality of tokens for an entire preset window.

According to an embodiment, the second time-series token may be set differently according to a learning method of the first module 10. The second time-series token may share tokens for a certain time window with the first time-series token input to the encoder block 100.

According to another embodiment, the second time-series token may include tokens for a time window following the first time-series token, and include tokens for a time window preceding the third time-series token.

According to an embodiment, the decoder input layer 210 may be an embedding layer, and the tokens processed in the decoder input layer 210 may be referred to as embedding vectors.

The decoder layer 220 may decode context information output from the encoder block 100, and learn a feature of the time-series data set input to the first module 10 based on the decoded context information and the embedded second time-series token.

The decoder block 200 may include the plurality of decoder layers 220, the number of which may be a tuning value for optimization as a hyper parameter.

The decoder layer 220 may infer prediction data that is data of a battery cell for a time window after the second time-series token, based on the feature of the learned time-series data set.

The decoder layer 220 may include a mask self-attention layer 221, a normalization layer 222, an encoder-decoder attention layer 223, a normalization layer 224, a feed-forward layer 225, and a normalization layer 226.

The mask self-attention layer 221 may linearly transform a vector for the tokens included in the second time-series token to generate a query vector, a key vector, and a value vector.

The mask self-attention layer 221 may perform attention based on the tokens included in the second time-series token. However, the mask self-attention layer 221 may mask, at the time of performing attention, the tokens corresponding to the time window after each token is obtained, and then perform attention.

The masking may be an operation of preventing the decoder block 200 from referring to tokens for a time window after a time window subject to learning or processing. The attention except for the masking may be substantially the same as the attention of the self-attention layer 131 included in the encoder block 100.

For example, the mask self-attention layer 221 may perform attention based on the tokens included in the second time-series token input to the decoder block 200, and the attention performed by the mask self-attention layer 221 may be multi-head attention.

The normalization layer 222 may add the vector input to the mask self-attention layer 221 to the vector output from the mask self-attention layer 221 and normalize the summed vector, thereby preventing a loss of information. That is, the normalization layer 222 may perform residual connection and layer normalization on the output of the mask self-attention layer 221.

The encoder-decoder attention layer 223 may perform multi-head attention like the mask self-attention layer 221 or the self-attention layer 131, but may perform attention using both an output value of the encoder block 100 and an output value of the mask self-attention layer 221.

More specifically, the encoder-decoder attention layer 223 may perform attention using the context information output from the encoder block 100 and the vectors based on the tokens included in the second time-series token.

The encoder block 100 may transmit the context information to the encoder-decoder attention layer 223, and the context information may include a key vector and a value vector for an output value of the encoder layer 130.

The encoder-decoder attention layer 223 may generate an output value having an attention value for all of the tokens included in the second time-series token based on the query vector generated from the vector output through the mask self-attention layer 221 and the normalization layer 222 and the key vector and the value vector for the output value of the encoder layer 130.

According to an embodiment, the encoder-decoder attention layer 223 may perform multi-head attention, perform parallel attention on all of the tokens included in the second time-series token, and connect the generated output vectors for multiplication by an additional weight value matrix.

The normalization layer 224 may add the vector input to the encoder-decoder attention layer 223 to the vector output from the encoder-decoder attention layer 223 and normalize the summed vector, thereby preventing a loss of information. That is, the normalization layer 224 may perform residual connection and layer normalization on the output of the encoder-decoder attention layer 223.

The feed-forward layer 225 may be a fully connected layer including a plurality of hidden layers. A vector input to the feed-forward layer 225 may be output under an influence of a weight value applied between the hidden layers included in the feed-forward layer 225. The size of the hidden layers included in the feed-forward layer 225 may be a tuning value for optimization.

The normalization layer 226 may add the vector input to the feed-forward layer 225 to the vector output from the feed-forward layer 225 and normalize the summed vector, thereby preventing a loss of information. That is, the normalization layer 226 may perform residual connection and layer normalization on the output of the feed-forward layer 225.

The operations may be repeated as many times as the number of decoder layers 220. The vector output from the decoder layers 220 may have the same magnitude as a vector input from the decoder input layer 210 to the decoder layer 220.

The linear mapping layer 230 may be a fully connected layer where when the battery cell is in the normal state, the battery management system 30 determines prediction data predicted to be collected from the battery cell.

That is, the prediction data may be data predicted to be collected by the battery management system 30 when the battery cell is in the normal state at the time when the first module 10 generates the state information of the battery cell.

The prediction data may be data having the same dimension as the tokens included in the time-series data set input to the first module 10.

The determination block 300 may generate the first state information regarding the battery cell, based on the prediction data and the third time-series token.

The third time-series token may be time-series data actually collected from the battery cell by the battery management system 30 at the time when the state of the battery cell is determined.

The determination block 300 may compare the prediction data with the third time-series token to generate the first state information. For example, the determination block 300 may calculate a difference between the prediction data and the third time-series token and determine that the battery cell is in the abnormal state when the calculated difference exceeds a preset value.

According to an embodiment, the determination block 300 may train the encoder block 100 and the decoder block 200 based on the second state information received from the second module 20, thereby improving the accuracy of the generated prediction data.

The determination block 300 may compare the first state information with the second state information and correct learning parameters of the encoder block 100 and the decoder block 200 for generating the prediction data based on a comparison value. The accuracy of prediction data generation may be improved through correction of the learning parameters.

FIG. 3 is a block diagram showing a second module according to an embodiment disclosed herein.

The second module 20 may perform learning based on the experimental data set that is the data of the experimental battery cell collected under the preset experimental condition, and may generate the second state information based on the time-series data set regarding the battery cell.

The second module 20 may include a long short-term memory block 400, a convolution block 500, and a merging block 600.

The long short-term memory block 400 may include a shuffle layer 410, a long short-term memory layer 420, and a drop-out layer 430.

A convolution block 500 may include a convolution layer 510 and a pooling layer 520.

The experimental data set may be a data set in which the experimental data token for the preset experimental condition and state information of the experimental battery cell are matched to each other.

The long short-term memory block 400 may output a first feature based on the received time-series data set. The convolution block 500 may output a second feature based on the time-series data set.

The merging block 600 may generate the second state information by merging the first feature with the second feature.

The long short-term memory block 400 may include a shuffle layer 410, a long short-term memory layer 420, and a drop-out layer 430.

The shuffle layer 410 may facilitate processing of multivariate time-series data and improve processing speed and prevent over-fitting. The short-term/long-term memory layer 420 may be a network for processing sequentially input time-series data, and may include a recurrent layer 421 for recurrently processing a time-series data set by taking the output for the input token as an input and a memory layer 422 for keeping a processing result of the recurrent layer for a previous input token. That is, the long short-term memory layer 420 may be a long short-term memory (LSTM). According to an embodiment, the long short-term memory layer 420 may be an attention LSTM layer that performs attention.

The drop-out layer 430 may be a layer for preventing over-fitting and stochastically remove some connections from the fully connected layer.

A convolution block 500 may include a convolution layer 510 and a pooling layer 520. A convolution block 500 may include a plurality of convolution layers 510.

The convolution layer 510 may include a convolutional layer 511 that performs a convolution operation on the time-series data set, a compression layer 512 that reduces a dimension on an output of the convolutional layer 511, and an active layer 513 that normalizes an output of the compression layer 512 to apply a weight value.

The pooling layer 520 may be a layer that down-samples an operation result of the convolution layer 510 for size reduction, and a second feature may be output through the pooling layer 520.

The merging block 600 may determine the state of the battery cell from the input time-series data set by merging the first feature with the second feature. The state of the battery cell determined by the merging block 600 may be the second state information.

For example, the second state information may include information regarding determination of whether the battery cell is in the normal state or the abnormal state. The second state information may be the state information of the battery cell at a time point when the time-series data set is input, and more specifically, may be the state information of the battery cell at a time point when the third time-series token included in the time-series data set is collected.

The second module 20 may perform learning based on the experimental data set.

The experimental data set may be a data set in which the experimental data token for the preset experimental condition and state information of the experimental battery cell are matched to each other. The second module 20 may perform learning to input the experimental data token included in the experimental data set to the long short-term memory block 400 and the convolution block 500 to extract a feature corresponding to the experimental data token from each block, and may perform learning to cause the merging block 600 to merge the features to predict a state of the experimental battery cell.

More specifically, the second module 20 may perform learning by comparing the state information of the experimental battery cell matched to the experimental data token with the information predicted through the long short-term memory block 400, the convolution block 500, and the merging block 600, thereby improving the accuracy of learning.

After performing learning based on the experimental data set, the second module 20 may receive the time-series data set and predict the state of the battery cell based on the received time-series data set.

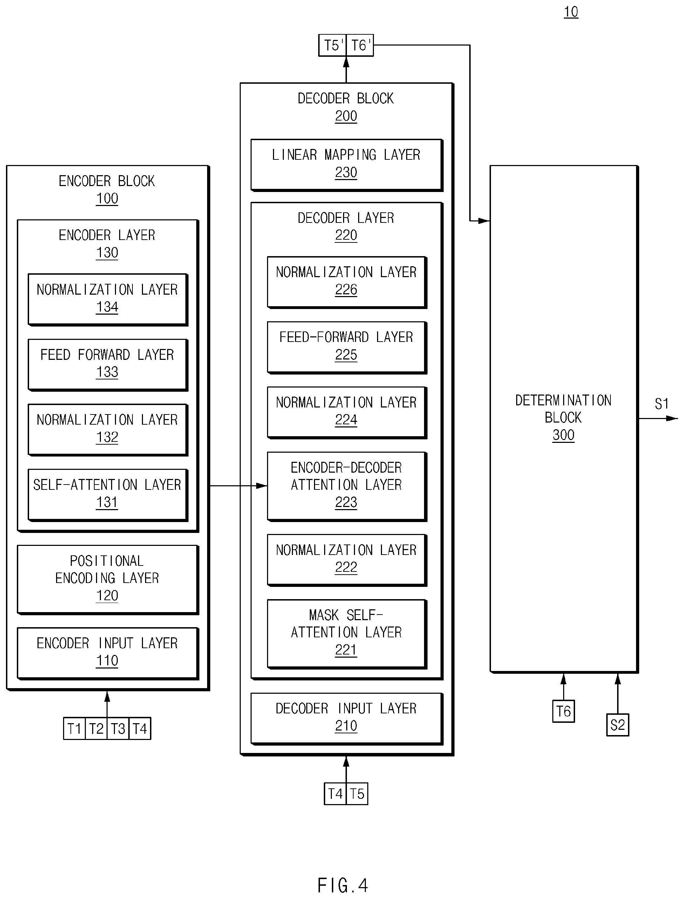

FIG. 4 is a flowchart of a battery cell state determination method of a first module according to an embodiment disclosed herein.

For convenience, a description will be made using an example where a time-series data set includes first to sixth tokens T1, T2, T3, T4, T5, and T6 and a state of a battery cell is determined for a time window in which the sixth token T6 is collected.

The first module 10 may select, from a time-series data set, a first time-series token for extracting context information of the time-series data set. For example, to determine a state of a battery cell for a time window in which the sixth token T6 is collected, the first time-series token may include first to fourth tokens T1, T2, T3, and T4.

The first time-series token may include tokens (e.g., T1, T2, T3, etc.) collected in time series before the token T6 collected in a time window that is a criterion for determining the state of the battery cell.

The encoder block 100 may receive the first time-series token and extract context information regarding the time-series data set from the received first time-series token.

The encoder block 100 may update the extracted context information each time when the time-series data set is input from the battery management system 30 to the first module 10.

A method of extracting the context information has been described already with reference to FIG. 2 and thus will not be described redundantly.

The decoder block 200 may receive an output value of the encoder block 100 as context information, and perform attention by applying the context information to the encoder-decoder attention layer 223 included in the decoder layer 220.

The decoder block 200 may select a second time-series token for generating prediction data from the time-series data set.

The second time-series token may include the token T5 collected immediately before collection of the token T6 collected in the time window that is the criterion for determining the state of the battery cell.

According to an embodiment, the second time-series token may include a plurality of tokens T4 and T5. The tokens T4 and T5 included in the second time-series token may be consecutive tokens having the temporal property. That is, the second time-series token may include tokens collected for consecutive time windows, such as the fourth token and the fifth token.

The decoder block 200 may generate prediction data T5' and T6' based on the context information and the second time-series token. According to an embodiment, the determination block 300 may compare the tokens T5 and T6 corresponding to the same time window as the prediction data T5' and T6' to improve the accuracy of a decoding algorithm of the decoder block 200.

The prediction data generated through the decoder block 200 may be consecutive data corresponding to tokens input to the decoder block 200.

According to another embodiment, the second time-series token input to the decoder block 200 may include only the fifth token T5 collected immediately before the time window that is the criterion for determining the state of the battery cell, and the decoder block 200 may generate the prediction data T6' for one time window based on the fifth token T5.

The prediction data T5' and T6' output from the decoder block 200 may be data that a battery cell in the normal state is predicted to have for a corresponding time window.

The determination block 300 may compare the token T6 actually collected from the battery cell in the time window that is the criterion for state determination with the prediction data T6' to generate first state information S1.

The determination block 300 may receive second state information S2 from the second module 20. The determination block 300 may take the received second state information S2 as ground truth for the input time-series data set (T1, T2, T3, T4, T5, and T6) and adjust a tuning value for the encoder block 100 and the decoder block 20 to improve the accuracy of a first state information S2 generation algorithm.

The encoder block 100 and the decoder block 200 may tune a learning algorithm based on the second state information S2, thereby improving the accuracy of the generated prediction data T5' and T6'.

The first module 10 may learn a prediction data generation method to generate the first state information S1 matching the input second state information S2, thereby improving the accuracy of the prediction data T5' and T6' generated based on the time-series data set.

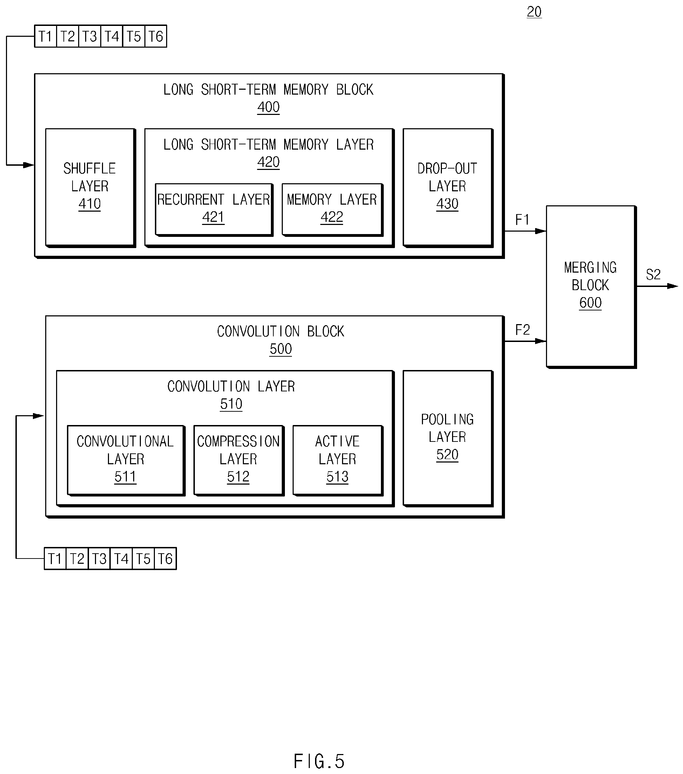

FIG. 5 is a flowchart of a battery cell state determination method of a second module according to an embodiment disclosed herein.

For convenience, a description will be made using an example where a time-series data set includes the first to sixth tokens T1, T2, T3, T4, T5, and T6 and a state of a battery cell is determined for a time window in which the sixth token T6 is collected.

The time-series data set may be input to the long short-term memory block 400 and the convolution block 500 in parallel.

The long short-term memory block 400 may extract a first feature F1 based on the consecutive tokens T1 to T6 included in the time-series data set.

The convolution block 500 may extract a second feature F2 based on the consecutive tokens T1 to T6 included in the time-series data set.

Operating methods of the long short-term memory block 400 and the convolution block 500 have been described with reference to FIG. 3 and thus will not be described redundantly.

The merging block 600 may generate the second state information S2 by merging the first feature F1 with the second feature F2.

The second module 20 may receive the time-series data set after completing learning based on an experimental data set, such that the accuracy of state information determination may be higher than that of the first module 10.

The experimental data set may be a data set in which the experimental data token for the preset experimental condition and state information of the experimental battery cell are matched to each other, such that the second module 20 may raise the accuracy of state information determination based on state information of the experimental battery cell.

Thus, the first module 10 may perform teacher forcing by taking the second state information S2 generated by the second module 20 as ground truth.

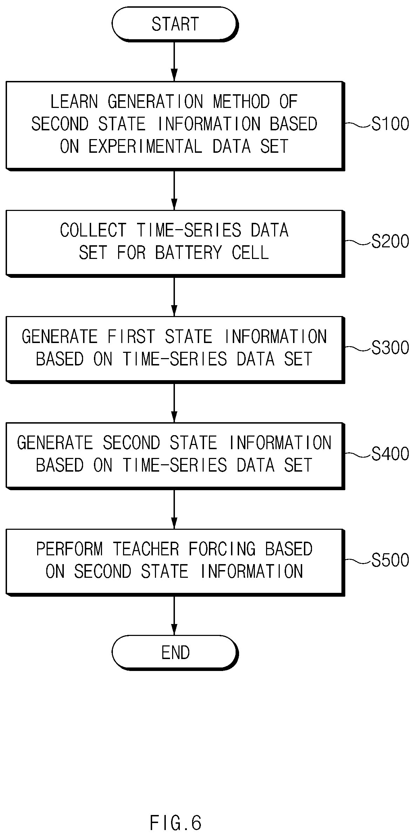

FIG. 6 is a flowchart of an operating method of a battery cell state determination apparatus according to an embodiment disclosed herein.

The second module 20 may learn a generation method of second state information based on an experimental data set, in operation S100.

The experimental data set may be data in which an experimental data token and state information regarding an experimental battery cell are matched to each other.

The second module 20 may generate second state information based on a time-series data set for a battery cell by learning a state information generation method in advance.

The battery management system 30 may collect the time-series data set for the battery cell in operation S200. The time-series data set may be time-series data collected by the battery management system 30 up to a time point when state determination for the battery cell is required.

The time-series data set may include a plurality of tokens obtained by applying a preset time window to the time-series data obtained from the battery cell.

The tokens included in the time-series data set may be consecutive data having a temporal property.

The first module 10 may generate the first state information based on the time-series data set in operation S300.

The first module 10 may include the encoder block 100, the decoder block 200, and the determination block 300, and the first state information may be state information of the battery cell for the time point when state determination for the battery cell is required. For example, the state information of the battery cell may include information regarding determination of whether the battery cell is in the normal state or the abnormal state.

The second module 20 may include the long short-term memory block 400, the convolution block 500, and the merging block 600, and the second state information may be state information of the battery cell for the time point when state determination for the battery cell is required, like the first state information.

The second module 20 may generate the state information of the battery cell in a manner different from that of the first module 10.

The first module 10 may perform teacher forcing on a first state information generation algorithm based on the second state information, in operation S500.

The first module 10 may improve the accuracy of a prediction data generation algorithm by using the second state information as ground truth.

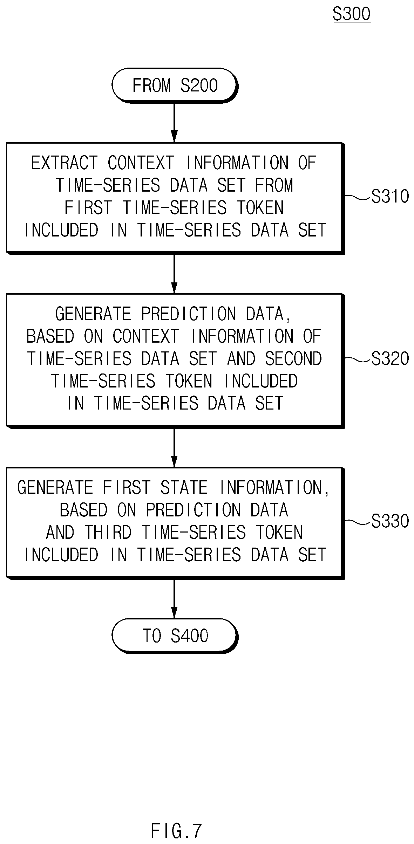

FIG. 7 is a flowchart of a first state information generation method according to an embodiment disclosed herein.

The encoder block 100 included in the first module 10 may extract context information of the time-series data set from the first time-series token included in the time-series data set, in operation S310.

The first time-series token may include a plurality of tokens for a preset window to extract the context information of the entire time-series data set.

According to an embodiment, the context information may include a key vector and a value vector for an output value of the encoder block 100.

The decoder block 200 included in the first module 10 may generate prediction data, based on context information of the time-series data set and a second time-series token included in the time-series data set, in operation S320.

The second time-series token may include a token collected immediately before a time point when state determination of the battery cell is required. The second time-series token may include tokens having a temporal property.

The prediction data may be data predicted to be collected from the battery cell when the battery cell is in the normal state for the time point when state determination of the battery cell is required.

The decoder block 200 may generate the prediction data by using the query vector, obtained from the second time-series token, and the key vector and the value vector for the output value of the encoder block 100.

The determination block 300 may generate the first state information, based on the prediction data and the third time-series token included in the time-series data set, in operation S330.

The third time-series token may be actual data of the battery cell, obtained from the battery cell, at the time point when state determination of the battery cell is required.

The determination block 300 may compare the prediction data with the third time-series token to determine whether the battery cell is in the normal state, and generate the first state information.

That is, when the battery cell is in the normal state, the determination block 300 may compare the prediction data, which is data the battery cell is predicted to have, with the third time-series token, which is actual data of the battery, thereby determining the state of the battery cell.

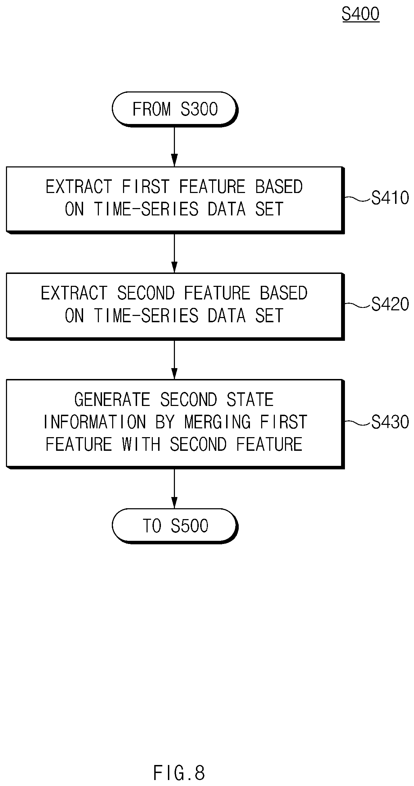

FIG. 8 is a flowchart of a second state information generation method according to an embodiment disclosed herein.

The long short-term memory block 400 included in the second module 20 may extract the first feature based on the time-series data set, in operation S410.

The long short-term memory block 400 may be an LSTM block including the recurrent layer 421 and the memory layer 422.

The convolution block 500 included in the second module 20 may extract the second feature based on the time-series data set, in operation S420.

The convolution block 500 may include the convolutional layer 511 that performs a convolution operation.

The merging block 600 included in the second module 20 may generate the second state information by merging the first feature with the second feature, in operation S430.

The first module 10 may perform teacher forcing based on the second state information.

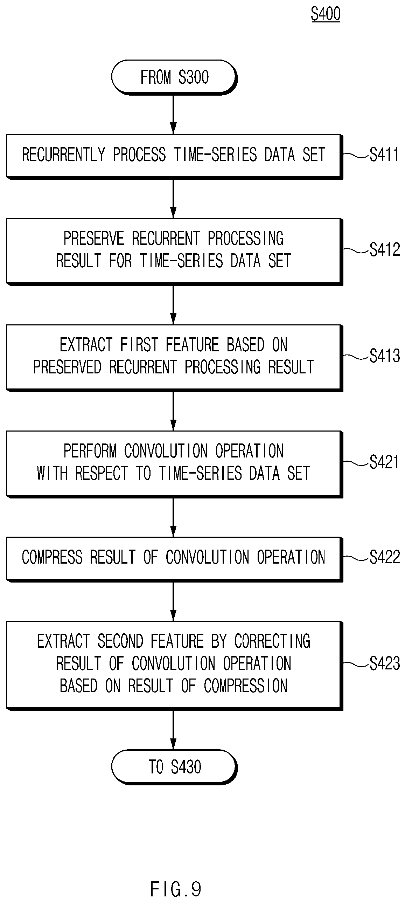

FIG. 9 is a flowchart of a second state information generation method according to another embodiment disclosed herein.

The long short-term memory block 400 included in the second module 20 may recurrently process the time-series data set, in operation S411.

Recurrent processing of the time-series data set may be performed by the recurrent layer 421 included in the long short-term memory block 400.

The long short-term memory block 400 may preserve a recurrent processing result with respect to the time-series data set, in operation S412.

The recurrent processing result of the time-series data set may be preserved by the memory layer 422 included in the long short-term memory block 400.

The long short-term memory block 400 may extract the first feature based on the preserved recurrent processing result, in operation S413.

The convolution block 500 included in the second module 20 may perform a convolution operation with respect to the time-series data set, in operation S421.

The convolution operation may be performed in the convolutional layer 511 including the plurality of hidden layers.

The convolution block 500 may compress a result of the convolution operation, in operation S422.

Compression may be performed in the compression layer 512 included in the convolution block 500.

The convolution block 500 may extract the second feature by correcting the result of the convolution operation based on a result of compression, in operation S423.

The merging block 600 may generate the second state information based on the extracted first feature and second feature.

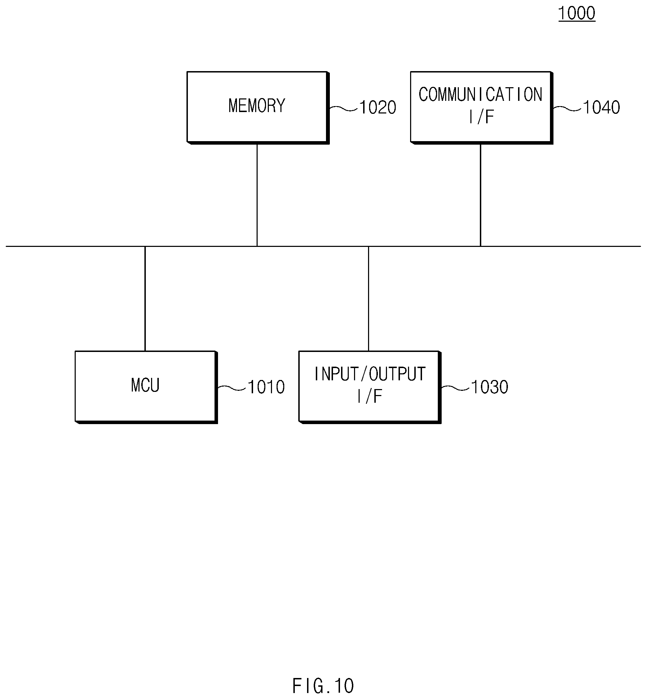

FIG. 10 is a block diagram showing a hardware configuration of a computing system for performing an operating method of a battery cell state determination apparatus, according to an embodiment disclosed herein.

Referring to FIG. 10, a computing system 1000 according to an embodiment disclosed herein may include an MCU 1010, a memory 1020, an input/output I/F 1030, and a communication I/F 1040.

The MCU 1010 may be a processor that executes various programs (e.g., a battery cell voltage or current collection program, a control program of a relay included in a battery pack, a battery cell remaining life calculating program, a battery cell capacity deterioration diagnosis program, a battery cell resistance deterioration determining program, etc.) stored in the memory 1020, processes various information including remaining life information of the battery cell, capacity deterioration information of the battery cell, and resistance deterioration information of the battery cell through these programs, and executes the above-described functions of the battery cell state determination apparatus shown in FIG. 1.

The memory 1020 may store various programs regarding log information collection and diagnosis of the battery, etc. The memory 1020 may store, as time-series data for the battery cell, various information current, voltage, and charge/discharge condition information of the battery, voltage information of the battery cell in a charge/discharge cycle period within a preset number of times, dQ/dV information of the battery cell in the charge/discharge cycle period within a preset number of times, etc. The memory 1020 may include operating algorithms of the modules 10 and 20 shown in FIG. 1.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery cell state determination apparatus may receive an experimental data set for an experimental battery cell from a separately provided external server through the communication I/F 1040. The battery cell determination apparatus may store the received experimental data set in an experimental data base. According to an embodiment, the experimental data base may be provided outside the battery state determination apparatus.

As such, a computer program according to an embodiment disclosed herein may be recorded in the memory 1020 and processed by the MCU 1010, thus being implemented as a module that performs functions shown in FIG. 1.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery cell state determination apparatus comprising:
a first module configured to generate first state information regarding a battery cell, based on a time-series data set regarding the battery cell; and
a second module configured to generate second state information regarding the battery cell, based on the time-series data set,
wherein the first module is further configured to perform learning using teacher forcing based on the second state information.

2. The battery cell state determination apparatus of claim 1, wherein the time-series data set comprises a plurality of time-series tokens which are consecutive data having a temporal property.

3. The battery cell state determination apparatus of claim 1, wherein the first module comprises:
an encoder block configured to extract context information of the time-series data set from a first time-series token included in the time-series data set;
a decoder block configured to generate prediction data, based on context information of the time-series data set and a second time-series token included in the time-series data set; and
a determination block configured to generate the first state information based on the prediction data and a third time-series token included in the time-series data set.

4. The battery cell state determination apparatus of claim 3, wherein the first module is further configured to correct the prediction data based on the second state information.

5. The battery cell state determination apparatus of claim 3, wherein the third time-series token is data collected from the battery cell at a time point when a state of the battery cell is determined.

6. The battery cell state determination apparatus of claim 3, wherein the third time-series token is data predicted to be collected from the battery cell when the battery cell is in a normal state.

7. The battery cell state determination apparatus of claim 1, wherein the second module comprises:
a long short-term memory block configured to extract a first feature based on the time-series data set;
a convolution block configured to extract a second feature based on the time-series data set; and
a combination block configured to generate the second state information by combining the first feature with the second feature.

8. The battery cell state determination apparatus of claim 7, wherein the long short-term memory block comprises:
a recurrent layer configured to recurrently process the time-series data set; and
a memory layer configured to preserve a processing result of the recurrent layer.

9. The battery cell state determination apparatus of claim 7, wherein the convolution block comprises a convolution layer configured to perform a convolution operation with respect to the time-series data set.

10. The battery cell state determination apparatus of claim 9, wherein the convolution block comprises:
a compression layer configured to compress an operation result of the convolution layer; and
an active layer configured to correct the operation result of the convolution layer based on an operation result of the compression layer.

11. The battery cell state determination apparatus of claim 1, wherein the second module is further configured to perform learning based on an experimental data set, and
the experimental data set is a data set in which data of an experimental battery cell, collected under a preset experimental condition, and state information of the experimental battery cell are matched to each other.

12. An operating method of a battery cell state determination apparatus, the operating method comprising:
collecting a time-series data set for a battery cell;
generating first state information regarding the battery cell, based on the time-series data set;
generating second state information regarding the battery cell, based on the time-series data set; and
performing teacher forcing based on the second state information.

13. The operating method of claim 12, wherein the generating of the first state information comprises:
extracting context information of the time-series data set from a first time-series token included in the time-series data set;
generating prediction data, based on context information of the time-series data set and a second time-series token included in the time-series data set; and
generating the first state information based on the prediction data and a third time-series token included in the time-series data set.

14. The operating method of claim 12, wherein the generating of the second state information comprises:
extracting a first feature based on the time-series data set;
extracting a second feature based on the time-series data set; and
generating the second state information by combining the first feature with the second feature.

15. The operating method of claim 14, wherein the extracting of the first feature comprises:
recurrently processing the time-series time set;
preserving a recurrent processing result with respect to the time-series data set; and
extracting the first feature based on the preserved recurrent processing result.

16. The operating method of claim 14, wherein the extracting of the second feature comprises:
performing a convolution operation with respect to the time-series data set;
compressing a result of the convolution operation; and
extracting the second feature by correcting the result of the convolution operation based on a result of the compression.

17. The operating method of claim 12, further comprising learning a generation method of the second state information based on an experimental data set,
wherein the experimental data set is a data set in which data of an experimental battery cell, collected under a preset experimental condition, and state information of the experimental battery cell are matched to each other.
